# EUROPEAN PATENT APPLICATION

(11) **EP 1 971 069 A1**
(43) Date of publication of application: **17.09.2008**
(21) Application number: 07005290.7
(22) Date of filing: 14.03.2007
(51) Int. Cl.: H04L 7/04, H03L 7/099, H04L 25/02, H04L 12/40

(54) **Data communication system with frequency generation in a slave unit**

(71) Applicant: Nec Electronics (Europe) GmbH, 40472 Düsseldorf (DE)
(72) Inventor: Kühne, Peter, 37115 Duderstadt (DE); Laschewski, Rüdiger, 47877 Willich (DE); Turski, Klaus, 40545 Düsseldorf (DE)
(74) Representative: Glawe, Delfs, Moll

(57) **Abstract**

The present invention relates to a data communication system comprising a master and at least a slave unit connected to the master unit via a bus. The master unit and the slave unit are adapted to communicate with each other using a predetermined protocol, wherein each slave unit comprises an oscillator (1) to generate a slave system frequency.

In order to avoid complicated and expensive quartz oscillators etc. the invention proposes to use in the slave unit an adjustable oscillator and a correction unit (7) to adjust the frequency of the oscillator (1) depending on information included in the protocol.

Preferably, the oscillator (1) is a ring oscillator comprising a plurality of inverters connected in a ring.

## Description

The present invention relates to a data communication system according to the preamble of claim 1 and a corresponding method wherein a slave system frequency is generated in a slave unit which communicates with a master unit.

Such a system is for instance known as L1N (local interconnect network).

Today's LIN solutions mostly deal with software support for single channel LIN implementations. Either based on standard UART hardware (Universal Asynchronous Receiver Transmitter) or using an enhanced UART hardware only rudimentary support is given for LIN specific protocol issues.

Current automotive implementations are made by very isolated network notes leading to distributed performance without an adequate utilisation.

Supporting larger networks requires strictly planning including the offer for enough performance also within slave nodes (there are e.g. up to 15 nodes within a L1N network) to support small and lean sensors and actuators. While the pure amount of LIN nodes within the car will increase in the future the costs have to be decreased, allowing more comfortable functionality with stable overall system costs.

Especially the need of expenses and space consuming external oscillators or resonators is a major draw bag for LIN slave applications.

Implementing common system forces the designer to provide a large space for a quartz or an other oscillator and the required external parts such as capacitors or resonators. In addition the total costs of these elements are rather high compared to the microcontroller itself.

It is therefore an object of the invention to provide a data communication method and a system comprising a master unit and a slave unit wherein in the slave unit a slave system frequency can be generated with high accuracy and wherein an oscillator in the slave unit can be easily integrated.

This object is achieved by a data communication system according to claim 1 and by a method according to claim 11; the dependent claims are related to further developments of the invention.

According to the invention it is proposed to use an adjustable oscillator for generating the slave system frequency wherein the frequency of the oscillator is adjusted depending on information included in a protocol received by the slave unit from the master unit.

According to the invention the protocol includes a synchronization field including a wave form having a reference frequency. This reference frequency is generated by a high accuracy oscillator in the master unit, and accordingly the adjustable oscillator can be controlled with high accuracy. Accordingly it is possible to use as oscillator in a slave unit a device which per se has no high accuracy but which can be adjusted each time the protocol is received by the slave unit.

To this end according to an embodiment of the invention the adjustable oscillator is a ring oscillator which is preferably constituted by a serial connection of inverters. Such a ring oscillator can be easily integrated in a semiconductor circuit device.

In order to avoid glitches when adjusting the oscillator the oscillator can comprise first and second sub-oscillators wherein one of the sub-oscillators is generating the slave system frequency whereas the other sub-oscillator is adjusted in frequency and wherein after adjustment the sub-oscillator having the corrected frequency is selected.

Preferably the output pulses of the oscillator are counted during a time period determined by reference pulses included in the protocol, and the counted value is compared with a reference value.

The system according to the invention is in particular suitable for systems having serial buses, in particular LIN systems.

Embodiments of the present invention are described with reference to the accompanying drawings.
- Fig. 1: shows a part of the waveform of a protocol transmitted from a master unit to a slave unit,
- Fig. 2: schematically shows a system comprising an adjustable oscillator and a correction unit,
- Fig. 3: shows details of the unit of Fig. 2,
- Fig. 4: shows a principle scheme of a ring oscillator,
- Fig. 5: shows details of a ring oscillator, and
- Fig. 6: shows an example of an oscillator having two sub-oscillators.

In a LIN application a master unit (MCU) communicates with a plurality of slave units via serial buses wherein the slave units are usually adapted to control actuators, sensors etc. for instance in a automobile. Usually the master unit comprises an oscillator of high accuracy, and the master unit communicates with the slave units by using a certain protocol. The structure of such a LIN system is already known, and is accordingly not further described in detail.

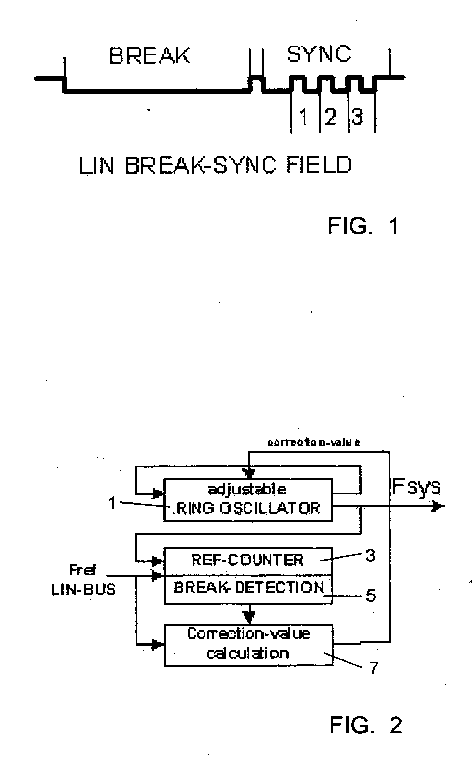

Fig. 1 shows a part of the protocol, namely the wave form of a break-sync field included in the protocol. In particular the LIN protocol provides a dedicated break symbol to signal the beginning of a new frame. A break is always generated by the scheduler task (in the master unit) and it shall be of 13 to 21 bits of dominant value including the start bit, followed by a break delimiter. The break delimiter shall be at least one nominal bit time long. This break delimiter is followed by a sync part of the field, in the example shown in Fig. 1 comprising three pulses having the reference frequency generated by the master unit.

Fig. 2 shows the structure of an adjustable ring oscillator included in the slave unit. The frequency F_{sys} of the ring oscillator 1 is determined using a reference counter 3 and break detection 5 to perform a correction value calculation 7 in order to adjust the frequency of oscillator 1.

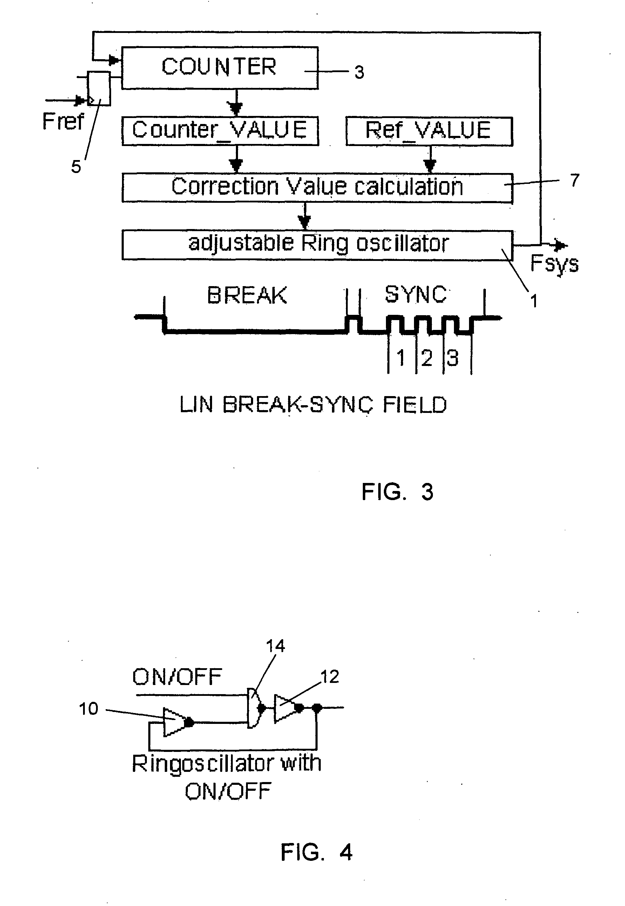

Details of this structure are shown in Fig. 3 wherein the break detector 5 monitors the LIN protocol in order to detect the break-sync field. Upon detection of the break the counter 3 is operated to count the output pulses of the ring oscillator 1 wherein the counter is started by appearance of the first positive edge of the sync field and is stopped by the last positive edge of the sync field. Accordingly, in the example shown in Fig. 3 three periods of pulses of the sync field are utilized to count the pulses of the oscillator 1. The count value determined by counter 3 is compared to a predetermined reference value which is a preset target value, and depending on the result of this comparison the correction value calculator 7 calculates a correction value and adjusts the ring oscillator 1 accordingly. Namely, if the counter value corresponds to the reference value no correction is necessary, in case the counter value is lower than the reference value the frequency of oscillator 1 is increased, and in case the counter value is higher than the reference value the frequency is reduced.

Fig. 4 shows the principle structure of a switchable ring oscillator. A ring oscillator is usually constituted by inverters 10, 12 connected in series, wherein the output of the last inverter 12 is connected to the input of the first inverter 10. In order to control the ring oscillator an AND gate 14 is interposed between the two inverters so that by controlling the input of the AND gate 14 the oscillator can be switched on/off.

Using such basic ring oscillator circuits the frequency depends on the delay of the inverters, one inverter has a typical delay of 0.1 ns such that the corresponding frequency is 1/0.1 = 3 GHz to constitute an adjustable ring oscillator a chain of different delay items will be connected, each with the possibility to be switched on/off.

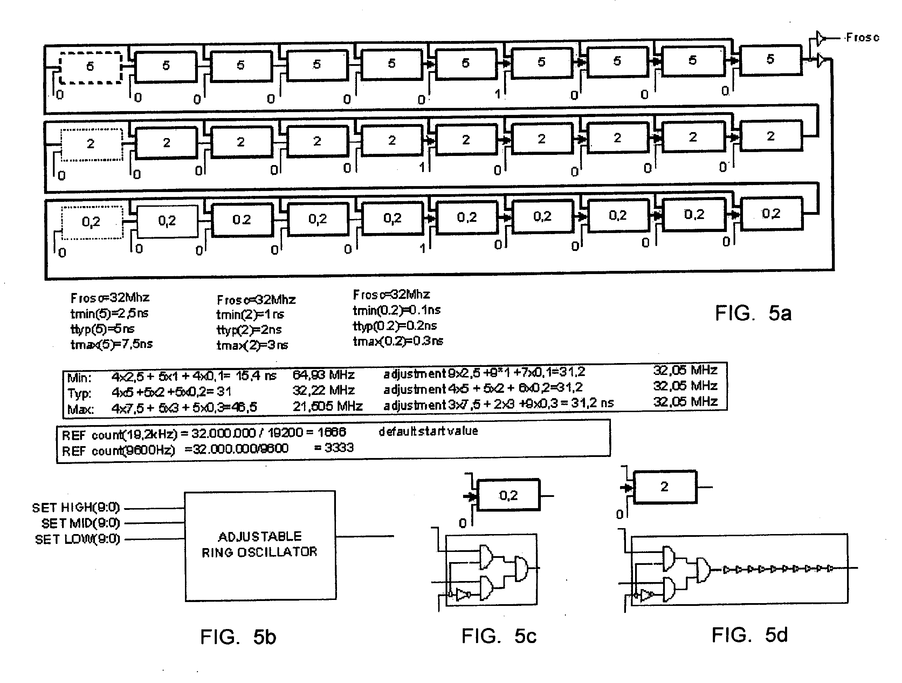

To provide a fine tuning as needed by the LIN specification different delay elements are necessary, for instance 0.2 ns elements, 2 ns elements and 5 ns elements. Details of a 0.2 ns element and of a 2 ns element are shown in Figs. 5c and 5d. Fig. 5a shows details of the adjustable ring oscillator comprising chains of different delay elements as mentioned above within examples for adjustments to different frequencies are given.

The control signals set high, set mid and set low shown in Fig. 5b are generated by the control circuit 7 depended on the difference between reference value and counter value. The delay elements right of the 1-signal are active in a chain. In the example above five 0.2 element, five 2 ns elements and four 5 ns elements are active so that the typical delay of the chain is 5 x 0.2 + 5 x 2 + 4 x 5 = 31 ns (corresponding to 32.22 MHz). The final frequency is dependent on voltage, temperature and chain length. Depending on, process and technology the delay of a typical chain with nominal 5 ns can vary between 2,5 to 7,5 ns.

According to the invention the slave system clock is writing nominal with 8 or 16 MHz ± 5%.

The start of the sequence is used to adjust the slave baud frequency.

If the break field is received it will be used to stop the process of frequency detection in generation. On the incoming sync field the measurement of the frequency as provided by the bus master is started, and the measurement itself is applied between three positive edges of the sync field. Based on the three results a correction values calculated and switched to the adjustable ring oscillator.

Using the above described process the LIN slave is able to receive the LIN identifier and to handle the following data byes and the check sum with the correct baud rate.

The next LIN frame will again be started using the break-sync mechanism allowing the LIN slave to re-synchronize the current baud rate on the LIN bus.

According to the invention the data communication system is provided which has a low cost-high accuracy on a chip system frequency generation without any need of software for the support of LIN protocol.

The system according to the invention has this automatic baud rate detection and generation and system frequency generation based on a high speed ring oscillator which can be implemented by simple hardware without need of external oscillators, capacitors or resonators.

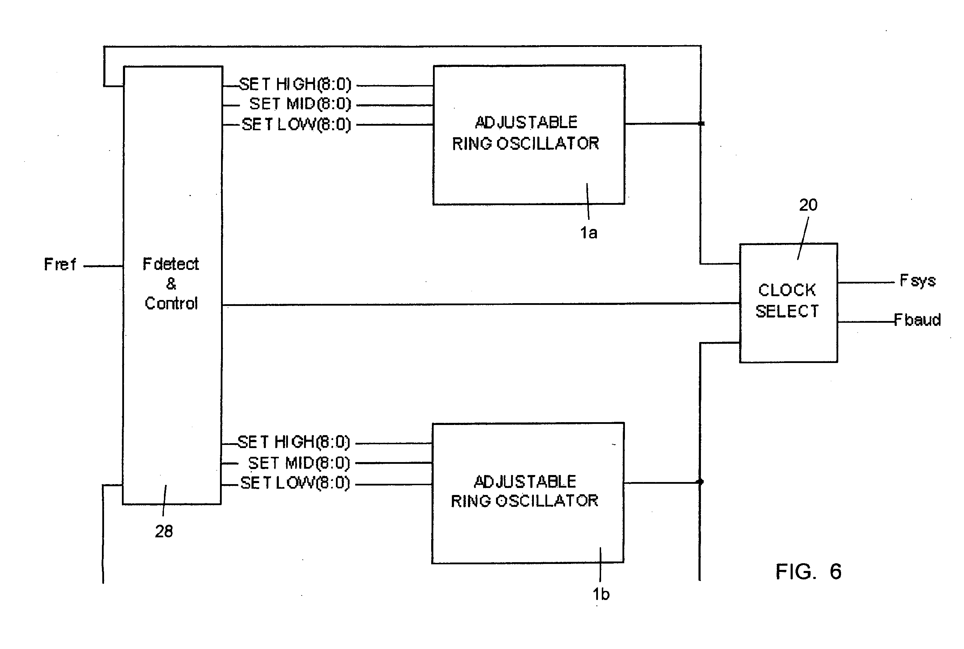

Fig. 6 shows a system in which the ring oscillator 1 is constituted by two sub-oscillators 1a and 1b. In this system the break detection and correction value calculation is performed by a common controller 28 which controls further a clock select 20. Furthermore, the ring oscillators 1a and 1b have the same constitution as the ring oscillator 1 mentioned before. In the system of Fig. 6 one of the sub-oscillators is operated to generate the slave system frequency, and accordingly its output is selected by the clock select 20. The other ring oscillator is operated so that its output can be measured as mentioned before and so that the ring oscillator can be adjusted accordingly. After the adjustment has been conducted the clock select 20 selects the sub-oscillator 1a or 1b which has been adjusted in order to generate the slave system frequency whereas the other 1b or 1a is used for adjustment and measurement. Accordingly, by switching between the two sub-oscillators glitches can be avoided.

## Claims

1. Data communication system comprising a master unit and at least a slave unit connected to the master unit via a bus, wherein the master unit and the slave unit are adapted to communicate with each other using a predetermined protocol and wherein each slave unit comprises an oscillator (1) to generate a slave system frequency (F_{sys}), **characterized in that** the oscillator (1) is an adjustable oscillator and that each slave unit comprises a correction unit (7) to adjust the frequency of the oscillator (1) depending on information included in the protocol.

2. Data communication system according to claim 1, wherein the protocol includes a synchronisation field including a waveform having a reference frequency.

3. Data communication system according to claim 1 or 2, wherein the oscillator (1) is a ring oscillator comprising a plurality of inverters connected in a ring.

4. Data communication system according to claim 3, wherein inverters (10, 12) of different delay times are provided.

5. Data communication system according to one of claims 1 to 4, wherein the oscillator (1) comprises first adjustable sub-oscillator (1a) and a second adjustable sub-oscillator (1b) and a selection unit (20) for selecting the output of one of the sub-oscillators.

6. Data communication system according to one of claims 1 to 5, wherein the correction unit (7) comprises a counter (3) for counting output pulses of the oscillator (1) during a measurement period which is determined by the reference pulses included in the protocol.

7. Data communication system according to claim 6, wherein the correction unit (7) comprises a comparator for comparing the count value of the counter (3) with a reference value wherein the correction unit (7) is adapted to adjust the frequency of the oscillator (1) dependent on the count result.

8. Data communication system according to one of claims 1 to 7, wherein the bus is a serial bus.

9. Data communication system according to claims 1 to 8, wherein the system is a LIN system.

10. Data communication according to one of claims 1 to 9, wherein a plurality of slave units and plurality of buses are provided.

11. Method of generating a slave system frequency in a data communication system comprising a master unit and at least a slave unit connected via a bus comprising the steps:
operating the master unit and the slave unit to communicate via a predetermined data protocol,
generating in the slave unit a slave system frequency,
detecting in the data protocol received by the slave unit a reference field,
measuring in the slave unit the slave system frequency during a time period determined by the reference field,
adjusting the slave system frequency depending on the measurement result.

12. Method according to claim 11, wherein measurement of the slave system frequency is performed by counting pulses having the slave system frequency during said time period.

13. Method according to claim 11, wherein the count value of the pulses is compared with a reference value.
